# EUROPÄISCHE PATENTSCHRIFT

(11) **EP 2 266 139 B1**
(45) Veröffentlichungstag und Bekanntmachung des Hinweises auf die Patenterteilung: **23.08.2017**
(21) Anmeldenummer: 09753505.8
(22) Anmeldetag: 31.03.2009
(51) Int. Cl.: H01L 31/0203, H01L 31/18, H01L 23/498, H01L 23/00, H01L 33/48, H01L 33/62, H01L 31/0232, H01L 33/00

(54) **OPTOELEKTRONISCHES BAUTEIL UND VERFAHREN ZUR HERSTELLUNG EINES OPTOELEKTRONISCHEN BAUTEILS**
OPTOELECTRONIC COMPONENT AND METHOD FOR PRODUCING AN OPTOELECTRONIC COMPONENT
COMPOSANT OPTO-ÉLECTRONIQUE ET PROCÉDÉ DE FABRICATION D'UN COMPOSANT OPTO-ÉLECTRONIQUE

(30) Priorität: 17.04.2008 DE 102008019269; 21.05.2008 DE 102008024704
(43) Veröffentlichungstag der Anmeldung: 29.12.2010
(73) Patentinhaber: OSRAM Opto Semiconductors GmbH, 93055 Regensburg (DE)
(72) Erfinder: JÄGER, Harald, 93049 Regensburg (DE); ZITZLSPERGER, Michael, 93047 Regensburg (DE)
(74) Vertreter: Epping - Hermann - Fischer
(86) Internationale Anmeldenummer: PCT/DE2009/000438
(87) Internationale Veröffentlichungsnummer: WO 2009/143789

(56) Entgegenhaltungen:
- WO-A1-2007/145237
- DE-U1-202004 005 228
- US-A1- 2005 017 330
- US-A1- 2005 151 142
- US-A1- 2005 280 016
- US-A1- 2007 029 570
- US-A1- 2007 126 093
- ANONYMOUS: "Leiterplatte" WIKIPEDIA, DIE FREIE ENZYKLOPÄDIE, [Online] 16. April 2008 (2008-04-16), XP002545520 http://de.wikipedia.org/wiki/Leiterplatte Gefunden im Internet: URL:http://de.wikipedia.org/w/index.php?ti tle=Leiterplatte&oldid=44965548> [gefunden am 2009-09-11]

## Beschreibung

Es wird ein optoelektronisches Bauteil angegeben.

Die Druckschriften US 2005/0017330, US 2007/0029570, US 2007/0126093 und US 2005/0280016 beschreiben jeweils ein optoelektronisches Bauteil.

Eine zu lösende Aufgabe besteht darin, ein optoelektronisches Bauteil anzugeben, das besonders kostengünstig herstellbar ist. Eine weitere zu lösende Aufgabe besteht darin, ein Verfahren zur Herstellung eines solchen optoelektronischen Bauteils anzugeben.

Die Erfindung betrifft ein optoelektronisches Bauteil gemäß Patentanspruch 1.

Gemäß zumindest einer Ausführungsform des optoelektronischen Bauteils umfasst das optoelektronische Bauteil einen Anschlussträger. Unter einem Anschlussträger ist dabei ein Träger für Komponenten des optoelektronischen Bauteils zu verstehen, auf dem diese Komponenten mechanisch befestigt und gegebenenfalls elektrisch angeschlossen sind.

Der Anschlussträger weist einen Trägerstreifen auf. Unter einem Trägerstreifen ist ein Leadframe zu verstehen, der aus einem elektrisch leitenden Material besteht oder zumindest ein elektrisch leitendes Material enthält. Der Trägerstreifen weist beispielsweise zwischen metallischen Verstrebungen oder Stegen und einem metallischen Rahmen Zwischenräume auf.

Der Trägerstreifen ist strukturiert. Das heißt, beispielsweise Verstrebungen des Trägerstreifens sind mit Strukturen versehen. Die Strukturierung kann mittels eines Ätzverfahrens erfolgt sein.

Bei vorliegendem Anschlussträger sind die Zwischenräume im strukturierten Trägerstreifen mit einem elektrisch isolierenden Material ausgefüllt. Der Trägerstreifen ist bevorzugt derart strukturiert, dass die Haftung zwischen dem elektrisch isolierenden Material und dem Trägerstreifen aufgrund der Strukturierung des Trägerstreifens im Vergleich zu einem unstrukturierten Trägerstreifen verbessert ist.

Gemäß einer Ausführungsform des optoelektronischen Bauteils umfasst dieses also einen Anschlussträger, der einen strukturierten Trägerstreifen umfasst, bei dem Zwischenräume im Trägerstreifen mit einem elektrisch isolierenden Material ausgefüllt sind. Dem optoelektronischen Bauteil liegt dabei unter anderem die Erkenntnis zugrunde, dass ein Ausfüllen von Zwischenräumen im Trägerstreifen zu einer mechanischen Versteifung oder Verfestigung des Trägerstreifens führen kann. Mittels des elektrisch isolierenden Materials in den Zwischenräumen des Trägerstreifens ist also ein besonders kostengünstiger und mechanisch stabiler Anschlussträger gegeben.

Mit anderen Worten bildet das elektrisch isolierende Material eine Matrix, in welche der strukturierte Trägerstreifen eingelagert ist. Der strukturierte Trägerstreifen ist derart in die Matrix aus dem elektrisch isolierenden Material eingebettet, das vorzugsweise Teile des Trägerstreifens vom elektrisch isolierenden Material unbedeckt bleiben und andere Teile des strukturierten Trägerstreifens mit dem Material benetzt sind. Dort wo das elektrisch isolierende Material den strukturierten Trägerstreifen benetzt, gehen Trägerstreifen und Material eine innige mechanische Verbindung miteinander ein. Diese mechanische Verbindung ist vorzugsweise bis Temperaturen von wenigstens 130° C im Dauerbetrieb stabil, sodass auch bei Erwärmung des Anschlussträgers aus strukturierten Trägerstreifen und elektrisch isolierendem Material keine Delamination des elektrisch isolierenden Materials vom strukturierten Trägerstreifen erfolgt. Kurzzeitig - beispielsweise beim Löten - ist die Verbindungen für Temperaturen bis 260° C stabil.

Gemäß zumindest einer Ausführungsform des optoelektronischen Bauteils umfasst das optoelektronische Bauteil einen optoelektronischen Halbleiterchip. Bei dem optoelektronischen Halbleiterchip kann es sich beispielsweise um einen Lumineszenzdiodenchip handeln. Der Lumineszenzdiodenchip kann durch einen Laserdiodenchip oder einen Leuchtdiodenchip gebildet sein. Ferner ist es möglich, dass es sich beim optoelektronischen Halbleiterchip um einen Detektorchip, wie beispielsweise einen Fotodiodenchip, handelt. Der optoelektronische Halbleiterchip ist vorzugsweise an einer Oberseite des Anschlussträgers befestigt und elektrisch angeschlossen. Der optoelektronische Halbleiterchip kann an einer Stelle des strukturierten Trägerstreifens aufgebracht sein, welche nicht vom elektrisch isolierenden Material bedeckt ist.

Gemäß zumindest einer Ausführungsform des optoelektronischen Bauteils umfasst dieses einen Anschlussträger mit einem strukturierten Trägerstreifen, bei dem Zwischenräume mit einem elektrisch isolierenden Material ausgefüllt sind. Darüber hinaus umfasst das optoelektronische Bauteil einen optoelektronischen Halbleiterchip, der auf einer Oberseite des Anschlussträgers befestigt und elektrisch angeschlossen ist.

Unter anderem aufgrund des beschriebenen Anschlussträgers, der aus wenigen Komponenten besteht und in wenigen Verfahrensschritten herstellbar ist, zeichnet sich das optoelektronische Bauteil durch eine besonders einfache und damit kostengünstige Herstellbarkeit aus.

Gemäß zumindest einer Ausführungsform des optoelektronischen Bauteils weist der Trägerstreifen zumindest eine Verankerungsstruktur auf. Das heißt, in den Trägerstreifen ist zumindest eine Verankerungsstruktur strukturiert. Die Strukturierung erfolgt dabei vorzugsweise durch einen ätztechnischen Prozess. Dabei können halbgeätzte Bereiche hergestellt werden, die als Verankerungspunkte des Trägerstreifens mit dem elektrisch isolierenden Material dienen.

Der Trägerstreifen kann beispielsweise stellenweise einen T-förmigen und/oder einen pilzförmigen Querschnitt aufweisen. Solche Querschnitte zeichnen sich durch Unterschneidungen oder Hinterschneidungen aus, welche Verankerungsstrukturen für das elektrisch isolierende Material bilden.

Ferner ist es möglich, dass sich Lochstrukturen im Trägerstreifen befinden, in denen sich elektrisch isolierendes Material befindet. Auch diese Lochstrukturen - beispielsweise Durchbrüche im Trägerstreifen - vergrößern die Oberfläche des Trägerstreifens und bilden Verankerungsstrukturen für das elektrisch isolierende Material.

Das heißt, die Verankerungsstrukturen wirken einer Delamination des elektrisch isolierenden Materials entgegen. Durch die Strukturierung des Trägerstreifens ist auch dessen Oberfläche gegenüber einem unstrukturierten Trägerstreifen vergrößert. Das heißt, für das elektrisch isolierende Material steht eine größere Oberfläche zur Verfügung, an der sie am Trägerstreifen haften kann. Auch aus diesem Grund ist bei einem strukturierten Trägerstreifen die Haftung des elektrisch isolierenden Materials gegenüber einem unstrukturierten Trägerstreifen vergrößert.
Gemäß zumindest einer Ausführungsform des optoelektronischen Bauteils schließt das elektrisch isolierende Material zumindest stellenweise bündig mit dem Trägerstreifen ab. Vorzugsweise schließt das elektrisch isolierende Material an der Oberseite und/oder der der Oberseite gegenüberliegenden Unterseite des Trägerstreifens bündig mit dem Trägerstreifen ab. Ferner ist es möglich, dass der Trägerstreifen das elektrisch isolierende Material an der Oberseite und/oder der Unterseite des Anschlussträgers überragt. Vorzugsweise ist der Trägerstreifen also an der Oberseite und/oder der Unterseite, bevorzugt an der Oberseite und der Unterseite des Anschlussträgers, vom elektrisch isolierenden Material unbedeckt. Das heißt mit anderen Worten, der Trägerstreifen ist an der Oberseite und/oder der Unterseite des Anschlussträgers frei zugänglich. Auf den Trägerstreifen können dann Komponenten des optoelektronischen Bauteils wie beispielsweise der optoelektronische Halbleiterchip befestigt werden.
Gemäß zumindest einer Ausführungsform des optoelektronischen Bauteils enthält oder besteht das elektrisch isolierende Material aus Silikon. Das elektrisch isolierende Material kann dabei beispielsweise aus Silikon bestehen, oder es kann aus einem Hybridmaterial, aus Epoxid und Silikon bestehen. Bei dem Hybridmaterial handelt es sich dabei vorzugsweise um ein Silikon-Epoxidharz-Hybridmaterial mit einem Epoxidharzanteil zwischen 30 und 70 Gew-%. Besteht das elektrisch isolierende Material aus Silikon, so weist es bevorzugt einen Haftvermittler auf, der die Haftung an den Trägerstreifen verbessert.

Außer den genannten Materialien sind auch andere elektrisch isolierende, temperaturbeständige und lötstabile Materialien zur Verwendung als oder in dem elektrisch isolierenden Material denkbar. Die genannten Materialien - insbesondere Epoxidharz und Silikon-Epoxidharz-Hybridmaterial - zeichnen sich durch eine besonders gute Haftung am Trägerstreifen aus.

Gemäß zumindest einer Ausführungsform enthält das elektrisch isolierende Material Füllstoffpartikel, die den thermischen Ausdehnungskoeffizienten des Anschlussträgers reduzieren. Bei den Füllstoffpartikeln kann es sich um Partikel eines Materials handeln, das einen geringen thermischen Ausdehnungskoeffizienten aufweist. Beispielsweise handelt es sich bei den Füllstoffpartikeln um Glaspartikel, um keramische Partikel und/oder um metallische Partikel.

Gemäß zumindest einer Ausführungsform des optoelektronischen Bauteils enthält das elektrisch isolierende Material einen Haftvermittler, der die Haftung an dem Trägerstreifen erhöht. Das heißt, das elektrisch isolierende Material mit dem Haftvermittler weist gegenüber einem elektrisch isolierenden Material ohne einen solchen Haftvermittler eine verbesserte mechanische Haftung am Trägerstreifen auf.

Gemäß zumindest einer Ausführungsform des optoelektronischen Bauteils umfasst der Trägerstreifen einen Grundkörper, der Kupfer enthält oder aus Kupfer besteht. Das heißt, die mechanisch tragenden Komponenten des Trägerstreifens bestehen aus oder enthalten Kupfer. Der Grundkörper kann dabei stellenweise mit einer Schicht bedeckt sein, die zumindest eines der folgenden Metalle enthält: Silber, Nickel, Platin, Gold, Palladium. Beispielsweise kann der Trägerstreifen an der Oberseite des Anschlussträgers, dort wo Komponenten des optoelektronischen Bauteils vorzugsweise befestigt werden, eine Schicht enthalten, welche die Lötbarkeit verbessert. Diese Schicht kann beispielsweise aus Silber bestehen. Es ist auch möglich, dass die Schicht eine Schichtenfolge aus Nickel und Gold umfasst, wobei das Nickel an den Grundkörper des Trägerstreifens grenzt und das Gold auf der dem Trägerstreifen abgewandten Seite der Nickelschicht liegt. Dabei kann auch eine Palladiumschicht zwischen der Nickel- und der Goldschicht angeordnet sein. Solche Schichtenfolgen zeichnen sich zum einen durch eine gute Bondbarkeit, zum anderen durch eine hohe mechanische Stabilität, insbesondere eine hohe Stabilität gegen Verkratzen aus.

Bei einer besonders einfach herstellbaren Ausführungsform des optoelektronischen Bauteils kann der Grundkörper des strukturierten Trägerstreifens nach dem Strukturieren vollständig mit einer der genannten Schichten beschichtet werden. In diesem Fall kann der Haftvermittler im elektrisch isolierenden Material so gewählt werden, dass er die Haftung zu dem außen liegenden Material der Schicht verbessert.

Gemäß zumindest einer Ausführungsform des optoelektronischen Bauteils ist der Anschlussträger kavitätsfrei. Das heißt, im Anschlussträger ist keine Ausnehmung oder Kavität oder Aussparung vorgesehen, in welcher Komponenten des optoelektronischen Bauteils angeordnet werden sollen.

Vielmehr ist der Anschlussträger im Wesentlichen eben ausgebildet. "Im Wesentlichen eben" bedeutet dabei, dass zumindest die Ober- und/oder Unterseite des Anschlussträgers im Rahmen der Herstellungstoleranz eben sind. Dabei können Teile des Trägerstreifens die durch das elektrisch isolierende Material gebildete Ebene jedoch überragen. Der Anschlussträger kann beispielsweise eine quaderförmige Form aufweisen.

Gemäß zumindest einer Ausführungsform des optoelektronischen Bauteils ist der optoelektronische Halbleiterchip von einem Vergusskörper umgeben, der ein Silikon enthält, wobei der Vergusskörper stellenweise direkt an das elektrisch isolierende Material des Anschlussträgers grenzt. Das Umhüllen des optoelektronischen Halbleiterchips mit dem Silikon kann beispielsweise in einem Prozess erfolgen, bei dem ein flüssiges Silikon verarbeitet wird. Beispielsweise finden Techniken wie Compression Molding, Liquid Transfer Molding oder Liquid Injection Molding Verwendung. Auch ein Vergießen oder ein Verarbeiten eines teilweise bereits ausgehärteten Silikons ist möglich. Ferner kann der Vergusskörper durch einen so genannten Liquid Silicone Rubber Prozess auf den Anschlussträger mit dem optoelektronischen Halbleiterchip aufgebracht werden. Das Umhüllen mit dem Vergusskörper kann in geschlossenen oder offenen Formen mittels Ein- oder Mehrkomponenten-Flüssigmaterialverarbeitung erfolgen. Der Anschlussträger kann bei den genannten Verfahren einen Teil der Vergussform bilden.

Der Vergusskörper kann stellenweise auch eine Linsenformung aufweisen. Beispielsweise kann zumindest ein Teil der Außenfläche des Vergusskörper eine refraktive oder difraktive Optik bilden. Der Vergusskörper ist dazu stellenweise nach Art einer Linse gewölbt.

Der Vergusskörper kann dabei aus Silikon bestehen oder aus einem Silikon-Epoxid-Hybridmaterial, wie es auch für das elektrisch isolierende Material in den Zwischenräumen des Trägerstreifens Verwendung findet.

Darüber hinaus ist es möglich, dass das Silikon-Epoxid-Hybridmaterial als tablettenförmiges Material im Transfer Molding oder auch als granulatförmiges Material im Compression Molding oder Transfer Molding verarbeitet wird.

Das hier beschriebene optoelektronische Bauteil macht sich dabei unter anderem die Erkenntnis zunutze, dass Silikon besonders gut an einem elektrisch isolierenden Material wie Silikon oder einem Silikon-Epoxid-Hybridmaterial haftet. Das heißt, aufgrund der Verwendung eines geeigneten elektrisch isolierenden Materials im Anschlussträger ist es möglich, ein Bauteil anzugeben, bei dem eine besonders gute mechanische Haftung zwischen einem Vergusskörper für den optoelektronischen Halbleiterchip und dem Anschlussträger besteht. Dies stellt einen großen Vorteil des optoelektronischen Bauteils gegenüber Bauteilen dar, bei denen der Anschlussträger beispielsweise aus einem Keramikmaterial gebildet ist.

Insbesondere ist es möglich, dass der Vergusskörper und das elektrisch isolierende Material in den Zwischenräumen des Trägerstreifens aus demselben Material bestehen. Dabei ist es möglich, dass das elektrisch isolierende Material Beimengungen wie elektromagnetische Strahlung absorbierende oder elektromagnetische Strahlung reflektierende Partikel enthält.

Der Vergusskörper und das elektrisch isolierende Material können aber auch aus unterschiedlichen Materialien bestehen. Auf diese Weise kann jeweils ein Material gewählt werden, das für den jeweiligen Einsatz besonders gut geeignet ist.

Alternativ oder zusätzlich zu einem Vergusskörper kann ein Abdecken des optoelektronischen Halbleiterchips mit einem Glasfenster, die Montage einer Glaslinse oder ähnliches erfolgen. Auch die Kombination des Umhüllens mittels konvertergefülltem Silikon oder Mehrfachmolding, das heißt alternierendes Aufbringen von Klarsilikon und konvertergefülltem Silikon (oder die umgekehrte Abfolge), ist denkbar. Auch eine dispensierte Linse ist durch eingeätzte Stoppkanten oder aufgeklebten oder anderweitig aufgebrachten Stoppkanten an der Oberseite des Anschlussträgers möglich.

Es wird ferner ein Verfahren zur Herstellung eines optoelektronischen Bauteils angegeben. Gemäß zumindest einer Ausführungsform des Verfahrens umfasst das Verfahren die folgenden Schritte:
- Bereitstellen eines Trägerstreifens,
- Strukturieren des Trägerstreifens mittels eines Ätzverfahrens,
- Ausfüllen von Zwischenräumen des Trägerstreifens mit einem elektrisch isolierenden Material mittels eines Siebdruckverfahrens zur Bildung eines Anschlussträgers, und
- Aufbringen einer Vielzahl von optoelektronischen Halbleiterchips auf dem Trägerstreifen.

Das heißt, gemäß zumindest einer Ausführungsform des Verfahrens wird das elektrisch isolierende Material mittels eines Siebdruckverfahrens in die Zwischenräume des Trägerstreifens eingebracht. Dabei kann die Maske für das Siebdruckverfahren vorteilhafterweise derart gewählt werden, dass Verstrebungen des Trägerstreifens, welche vom elektrisch isolierenden Material an ihrer Ober- beziehungsweise Unterseite nicht bedeckt werden sollen, durch die Maske ausgespart werden. Das heißt, das elektrisch isolierende Material wird gezielt nur in die Zwischenräume eingebracht. Beispielsweise die Oberseite des Trägerstreifens bleibt unbedeckt, sodass keine nachfolgende Strukturierung des elektrisch isolierenden Materials erfolgen muss. Dadurch ist es insbesondere auch möglich, einen Anschlussträger zu erzeugen, bei dem das elektrisch isolierende Material an der Ober- und/oder der Unterseite des Trägerstreifens bündig mit diesem abschließt. Ferner kann das Material derart dosiert in die Zwischenräume eingebracht werden, dass der Trägerstreifen an der Ober- und/oder Unterseite des Anschlussträgers das elektrisch isolierende Material überragt.

Gemäß zumindest einer Ausführungsform des Verfahrens wird eine Vielzahl von optoelektronischen Halbleiterchips auf den Trägerstreifen aufgebracht. In einem nachfolgenden Verfahrensschritt kann die Anordnung aus Trägerstreifen und Halbleiterchips dann vereinzelt werden, sodass ein optoelektronisches Bauteil erzeugt wird, das zumindest einen optoelektronischen Halbleiterchip umfasst.

Gemäß zumindest einer Ausführungsform des Verfahrens ist mittels des Verfahrens ein optoelektronisches Bauteil, wie es in zumindest einem der oben beschriebenen Ausführungsformen angegeben ist, herstellbar. Das heißt, die in Verbindung mit dem optoelektronischen Bauteil angegebenen Merkmale sind auch in Kombination mit dem beschriebenen Verfahren offenbart.

Gemäß zumindest einer Ausführungsform des Verfahrens werden die optoelektronischen Halbleiterchips nach dem Aufbringen auf den Anschlussträger mit einem Vergussmaterial zur Bildung eines Vergusskörpers umhüllt und die Anordnung aus Anschlussträger, optoelektronischem Halbleiterchip und Vergusskörper wird zu optoelektronischen Bauteilen vereinzelt, wobei die Vereinzelung durch den Vergusskörper hindurch erfolgt. Der Vergusskörper besteht dabei aus einem der oben beschriebenen Materialien und wird mittels der oben beschriebenen Verfahren hergestellt. Der Vergusskörper wird beispielsweise derart auf den Anschlussträger aufgebracht, dass er einen Großteil oder die gesamte Oberseite des Anschlussträgers bedeckt. Der Vergusskörper befindet sich auf diese Weise in direktem Kontakt zum elektrisch isolierenden Material des Anschlussträgers. Das heißt, der Vergusskörper und das elektrisch isolierende Material des Anschlussträgers berühren sich. Die Vereinzelung erfolgt beispielsweise durch Sägen, Lasertrennen, Brechen oder anderen Vereinzelungsprozessen. Insbesondere kann der Vereinzelungsprozess durch den Vergusskörper hindurch erfolgen, sodass Vergusskörper und Anschlussträger beim Vereinzeln durchtrennt werden. Das derart hergestellte optoelektronische Bauteil weist daher zumindest an Seitenflächen Vereinzelungsspuren auf, die sich am Anschlussträger und am Vergusskörper nachweisen lassen. Der Vergusskörper weist also Vereinzelungsspuren auf. Genauso weist der Anschlussträger Vereinzelungsspuren auf.

Das hier beschriebene optoelektronische Bauteil und insbesondere auch der hier beschriebene Anschlussträger zeichnen sich dabei unter anderem durch die folgenden Vorteile aus:
Bei dem Anschlussträger handelt es sich um ein geschlossenes und versteiftes Substrat. Aufgrund des elektrisch isolierenden Materials in den Zwischenräumen des Trägerstreifens ist im Unterschied zu einem herkömmlichen, nicht verstärkten Trägerstreifen, kein Abdecken der Unterseite des Trägerstreifens mit einem so genannten "Backside Tape" notwendig. Eine Kontamination der Unterseite des Anschlussträgers, wo sich beispielsweise Anschlussstellen für das optoelektronische Bauteil befinden, kann durch das gewählte Verfahren für das Einbringen des elektrisch isolierenden Materials in die Zwischenräume vermieden werden.

Ferner zeichnet sich das optoelektronische Bauteil durch ein besonders kostengünstiges Herstellungsverfahren aus, da kostengünstige Materialien, wie Trägerstreifen und das elektrisch isolierende Material, Verwendung finden. Ferner kann das elektrisch isolierende Material und damit der gesamte Anschlussträger an die Anforderungen des Vergusskörpers, mit dem der optoelektronische Halbleiterchip vergossen werden kann, angepasst werden. Dadurch ergibt sich ein optoelektronisches Bauteil, das mechanisch besonders stabil ist, da die Gefahr eines Ablösens zwischen Vergusskörper und Anschlussträger stark vermindert ist. Das heißt, durch die geeignete Wahl des elektrisch isolierenden Füllmaterials kann eine gute Haftung zum späteren Verguss, der aus dem gleichen oder einem ähnlichen Material bestehen kann, geschaffen werden. Dabei wird der Flächenanteil des Trägerstreifens am Anschlussträger an dessen Oberseite möglichst gering gehalten, sodass der Vergusskörper mit dem elektrisch isolierenden Material des Anschlussträgers eine besonders große Verbindungsfläche aufweist.

Vorteilhaft ergibt sich durch die Verwendung des elektrisch isolierenden Materials in den Zwischenräumen des Trägerstreifens, dass der Vergusskörper kaum oder gar keine mechanische Funktion zur Versteifung des Anschlussträgers übernehmen muss. Die Versteifung, das heißt, die mechanische Stabilisierung des Anschlussträgers, erfolgt im Wesentlichen durch das elektrisch isolierende Material.

Ferner können vorteilhaft die zum Auffüllen der Zwischenräume des Trägerstreifens verwendeten elektrisch isolierenden Materialien bezüglich ihrer Haftung am Trägerstreifen mittels Haftvermittler beziehungsweise bezüglich ihres thermischen Ausdehnungskoeffizienten mittels Einbringen von Füllstoffpartikel an die Erfordernisse des optoelektronischen Bauteils angepasst werden. Auch ist es möglich, den Trägerstreifen zur Haftverbesserung vorzubehandeln oder selektiv nicht oder anders als zum beispielsweise Löten benötigt, zu beschichten. Beispielsweise kann die Oberfläche des Trägerstreifens aufgeraut werden, was die Haftung zum elektrisch isolierenden Material weiter verbessert.

Auch die Dicke des Anschlussträgers kann je nach erwünschtem Einsatz des optoelektronischen Bauteils entsprechend gewählt werden.

Wird für den Grundkörper des Trägerstreifens beispielsweise Kupfer oder ein anderes gut Wärme leitfähiges Material verwendet, so zeichnet sich der Anschlussträger auch durch einen guten thermischen Leitwert aus, der im Bereich des Leitwert des Materials liegt, aus dem der Grundkörper des Trägerstreifens besteht. Das heißt, der thermische Widerstand des Anschlussträgers ist gegenüber anderen, beispielsweise keramischen Anschlussträgern, stark reduziert.

Das hier beschriebene optoelektronische Bauteil eignet sich dabei beispielsweise zum Einsatz in der Allgemeinbeleuchtung oder auch bei der Hinterleuchtung von LCD-Panels, in LCD-Bildschirmen oder TV-Geräten.

Im Folgenden werden das hier beschriebene optoelektronische Bauteil sowie das hier beschriebene Verfahren anhand von Ausführungsbeispielen und den zugehörigen Figuren näher erläutert

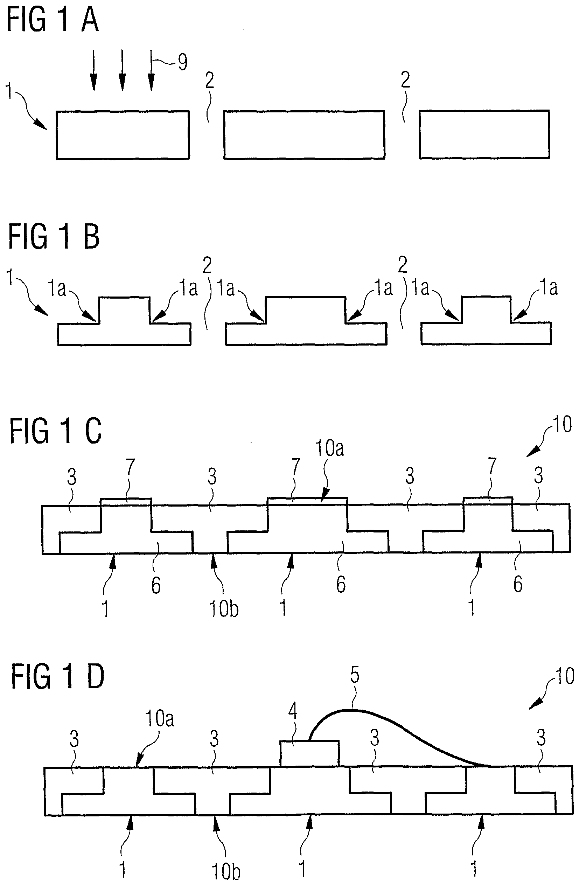

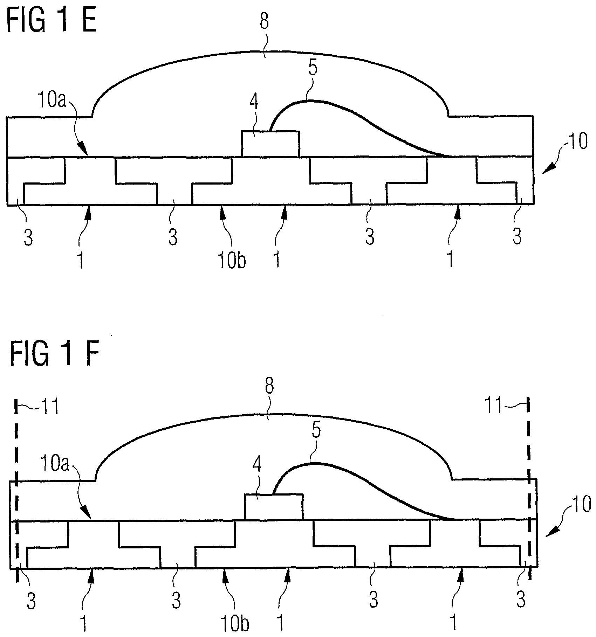

In Verbindung mit den Figuren 1A, 1B, 1C, 1D, 1E und 1F sind anhand schematischer Schnittdarstellungen Verfahrensschritte für ein Ausführungsbeispiel eines hier beschriebenen Verfahrens näher erläutert.

Die Figur 1F zeigt anhand einer schematischen Schnittdarstellung ein Ausführungsbeispiel eines hier beschriebenen optoelektronischen Bauteils.

Gleiche, gleichartige oder gleich wirkende Elemente sind in den Figuren mit denselben Bezugszeichen versehen. Die Figuren und die Größenverhältnisse der in den Figuren dargestellten Elemente untereinander sind nicht als maßstäblich zu betrachten. Vielmehr können einzelne Elemente zur besseren Darstellbarkeit und/oder zum besseren Verständnis übertrieben groß dargestellt sein.

In Verbindung mit der Figur 1A ist in einer schematischen Schnittdarstellung ein erster Verfahrensschritt eines hier beschriebenen Verfahrens zur Herstellung eines optoelektronischen Bauteils näher erläutert. Die Figur 1A zeigt dabei in einer Schnittdarstellung einen Trägerstreifen 1. Der Trägerstreifen 1 der Figur 1A ist noch unstrukturiert. Er weist Zwischenräume 2 auf, die zwischen Verstrebungen des Trägerstreifens 1 angeordnet sind. Der Trägerstreifen 1 wird mittels eines Ätzverfahrens, angedeutet durch die Pfeile 9, strukturiert.

Die Figur 1B zeigt den derart strukturierten Trägerstreifen 1. Der Trägerstreifen 1 ist halb geätzt. Der Trägerstreifen 1 weist Verankerungsstrukturen 1a auf. Im vorliegenden Ausführungsbeispiel weist der Trägerstreifen 1 dazu einen T-förmigen Querschnitt auf. Es ist jedoch auch möglich, dass der Trägerstreifen 1 beispielsweise einen pilzförmigen Querschnitt aufweist. In beiden Fällen sind die Verankerungsstrukturen 1a durch Hinterschneidungen gebildet, welche die Haftung eines später aufzubringenden, elektrisch isolierenden Materials verbessern. Ferner ist durch die Strukturierung des Leiterrahmens 1 dessen Oberfläche vergrößert, was die Haftung zu einem später aufzubringenden Material weiter verbessert.

In Verbindung mit der Figur 1C ist ein weiterer Verfahrensschritt beschrieben. In diesem Verfahrensschritt wird ein elektrisch isolierendes Material 3 in die Zwischenräume 2 des Trägerstreifens 1 eingebracht. Bei dem elektrisch isolierenden Material 3 handelt es sich beispielsweise um Silikon oder um ein Silikon-Epoxid-Hybridmaterial. Das isolierende Material 3 wird vorzugsweise mittels eines Siebdruckverfahrens (Screen Printing) in die Zwischenräume 2 eingebracht, derart, dass der so gebildete Anschlussträger 10 an seiner Oberseite 10a und seiner Unterseite 10b Bereiche aufweist, in denen der Trägerstreifen 1 frei zugänglich ist. Das heißt, der Trägerstreifen 1 bleibt an der Oberseite 10a und der Unterseite 10b des Anschlussträgers 10 vom elektrisch isolierenden Material 3 unbedeckt. Der Trägerstreifen 1 kann an der Oberseite 10a und der Unterseite 10b des Anschlussträgers 10 auch beispielsweise mittels eines Plasma-Verfahrens vom elektrisch isolierenden Material 3 gereinigt werden.

In der Figur 1C ist ferner dargestellt, dass der Trägerstreifen 1 einen Grundkörper 6 und eine Beschichtung 7 umfassen kann. Der Grundkörper 6 kann beispielsweise Kupfer enthalten oder aus Kupfer bestehen. Die Schicht 7 kann dabei zumindest eines der folgenden Metalle enthält: Silber, Nickel, Platin, Gold, Palladium. Die Schicht 7 kann beispielsweise aus Silber bestehen. Es ist auch möglich, dass die Schicht 7 eine Schichtenfolge aus Nickel und Gold umfasst, wobei das Nickel an den Grundkörper 9 des Trägerstreifens 1 grenzt und das Gold auf der dem Trägerstreifen 1 abgewandten Seite der Nickelschicht liegt. Dabei kann auch eine Palladiumschicht zwischen der Nickel- und der Goldschicht angeordnet sein.

Der Grundkörper 6 kann allseitig von der Schicht 7 bedeckt sein. Es ist aber möglich, dass die Schicht 7 nur an der Oberseite 10a des Anschlussträgers 10 vorhanden ist. Die Schicht 7 kann dabei vor oder nach Einbringen des elektrisch isolierenden Materials 3 in die Zwischenräume 2 des Trägerstreifens 1 auf den Grundkörper 6 aufgebracht werden. Aus Gründen der Übersichtlichkeit ist die Schicht 7 in den nachfolgenden Figuren nicht mehr dargestellt.

Nach dem Einbringen des elektrisch isolierenden Materials 3 in die Zwischenräume 2 erfolgt ein Aushärten des elektrisch isolierenden Materials 3. Danach kann ein chemisches oder mechanisches Reinigen der Oberseite 10a und/oder der Unterseite 10b des Anschlussträgers 10 insbesondere dort erfolgen, wo sich der Trägerstreifen 1 befindet. Im vorliegenden Ausführungsbeispiel schließt der Trägerstreifen 1 an Oberseite 10a und Unterseite 10b bündig mit dem elektrisch isolierenden Material 3 ab. An der Oberseite 10a werden nachfolgend Komponenten des optoelektronischen Bauteils befestigt. An der Unterseite 10b können sich die Anschlussstellen des Bauteils befinden. Das heißt, das Bauteil kann auf diese Weise oberflächenmontierbar (SMTmontierbar) sein.

In Verbindung mit der Figur 1D ist ein weiterer Verfahrensschritt näher erläutert. In diesem Verfahrensschritt werden eine Vielzahl von optoelektronischen Halbleiterchips 4 auf den Anschlussträger 10 aufgebracht. Der optoelektronische Halbleiterchip wird dazu auf einen freiliegenden Bereich auf der Oberseite 10a des Anschlussträgers 10 aufgelötet oder geklebt und mittels eines Drahtkontaktes 5 mit einem weiteren Steg oder einer Verstrebung des Leiterrahmens 1 verbunden. In der Figur 1D ist dabei nur ein einzelner optoelektronischer Halbleiterchip 4 gezeigt, da die Figur 1D nur einen kleinen Ausschnitt aus dem Anschlussträger 10 zeigt.

Bei dem optoelektronischen Halbleiterchip handelt es sich beispielsweise um eine Leuchtdiode. Beispielsweise kann es sich um eine Leuchtdiode in Dünnfilmbauweise handeln. Leuchtdioden in Dünnfilmbauweise strahlen einen überwiegenden Anteil der erzeugten Strahlung an ihrer den Anschlussträger abgewandten Oberseite ab, so dass ein Reflektor für seitlich austretende Strahlung entfallen kann.

Ferner können weitere Komponenten auf den Anschlussträger, wie beispielsweise ESD-Schutzkomponenten, Temperatursensoren, Helligkeitssensoren, Speicher mit Bauteilinformation und dergleichen auf den Anschlussträger 10 aufgebracht werden.

In Verbindung mit der Figur 1E ist ein nachfolgender Verfahrensschritt näher erläutert, bei dem ein Vergusskörper 8 mittels einem der oben beschriebenen Verfahren auf den Anschlussträger 10 derart aufgebracht wird, dass der optoelektronische Halbleiterchip vollständig vom Vergusskörper 8 umgeben ist. Der Vergusskörper 8 weist zum elektrisch isolierenden Material 3 eine besonders große Berührungsfläche auf, sodass eine gute Haftung zwischen dem elektrisch isolierenden Material 3 und dem Vergusskörper 8 eintritt. Beispielsweise besteht der Vergusskörper 8 aus einem der folgenden Materialien: Silikon, Silikon-Epoxidharz-Hybridmaterial.

Der Trägerstreifen 1 ist vorzugsweise derart strukturiert, dass an der Oberseite 10a des Anschlussträgers 10 der Trägerstreifen eine kleinere Querschnittsfläche aufweist, als an der Unterseite 10b des Anschlussträgers 10. Dies hat den Vorteil, dass das elektrisch isolierende Material 3 an der Oberseite 10a, dort wo eine Verbindung zum Vergusskörper 8 besteht, einen besonders großen Anteil der Fläche einnimmt. Dies verbessert die Haftung des Vergusskörpers 8 an den Anschlussträger 10. An der Unterseite hingegen nimmt das Wärme leitende Material des Trägerstreifens 1 den überwiegenden Teil der Fläche ein. Auf diese Weise kann im Betrieb eines optoelektronischen Halbleiterchips erzeugte Wärme besonders gut an die Umgebung des optoelektronischen Bauteils abgeleitet werden.
In Verbindung mit der Figur 1F ist ein abschließender Verfahrensschritt erläutert. In diesem Verfahrensschritt wird die Anordnung aus Trägerstreifen 10 und Vergusskörper 8 entlang der Schnittlinien 11 vereinzelt. Die Vereinzelung kann beispielsweise mittels einer der folgenden Verfahren erfolgen: Sägen, Lasertrennen, Brechen. Bei der Vereinzelung werden Vereinzelungsspuren sowohl im Anschlussträger 10 als auch im Vergusskörper 8 erzeugt. Die Vereinzelung ist also am fertig gestellten optoelektronischen Bauteil nachweisbar. Die Erfindung ist nicht durch die Beschreibung anhand der Ausführungsbeispiele auf diese beschränkt, sondern ist nur auf die Patentansprüche beschränkt. Beispielsweise kann auch im hier beschriebenen Anschlussträger und dem Verfahren zur Herstellung des Anschlussträgers eine Erfindung gesehen werden, die von der Verwendung von optoelektronischen Halbleiterchips unabhängig ist.
Diese Patentanmeldung beansprucht die Prioritäten der deutschen Patentanmeldungen DE 102008019269.4 und DE 102008024704. 9.

## Patentansprüche

1. Optoelektronisches Bauteil mit
- einem Anschlussträger (10), aufweisend einen strukturierten Trägerstreifen (1), bei dem Zwischenräume (2) mit einem elektrisch isolierenden Material (3) ausgefüllt sind,
- und einem optoelektronischen Halbleiterchip (4), der auf einer Oberseite (10a) des Anschlussträgers befestigt und elektrisch angeschlossen ist, wobei
- das elektrisch isolierende Material (3) stellenweise bündig mit dem Trägerstreifen (1) abschließt oder der Trägerstreifen (1) das elektrisch isolierende Material (3) überragt, und
- der Trägerstreifen (1) an der Oberseite (10a) und/oder an einer Unterseite (10b) des Anschlussträgers vom elektrisch isolierenden Material (3) unbedeckt ist, **dadurch gekennzeichnet, dass**
- der optoelektronische Halbleiterchip (4) von einem Vergusskörper (8) umgeben ist, der ein Silikon enthält und stellenweise direkt an das elektrisch isolierende Material (3) des Anschlussträgers (10) grenzt, und
- das elektrisch isolierende Material (3) ein Silikon enthält oder aus einem Silikon besteht.

2. Optoelektronisches Bauteil gemäß dem vorherigen Anspruch,
bei dem
der Vergusskörper (8) und der Anschlussträger (10) Vereinzelungsspuren aufweisen.

3. Optoelektronisches Bauteil gemäß einem der vorherigen Ansprüche,
bei dem der Trägerstreifen (1) zumindest eine Verankerungsstruktur (1a), insbesondere in Form von Hinterschneidungen, aufweist, wobei die Verankerungsstruktur (1a) die Haftung des elektrisch isolierenden Materials (3) am Trägerstreifen verbessert.

4. Optoelektronisches Bauteil gemäß einem der vorherigen Ansprüche,
bei dem der Trägerstreifen (1) zumindest stellenweise einen T-förmigen Querschnitt aufweist.

5. Optoelektronisches Bauteil gemäß einem der vorherigen Ansprüche,
bei dem der Trägerstreifen (1) zumindest stellenweise einen pilzförmigen Querschnitt aufweist.

6. Optoelektronisches Bauteil gemäß einem der vorherigen Ansprüche,
bei dem die zumindest eine Verankerungsstruktur (1a) durch Ätzen erzeugt ist.

7. Optoelektronisches Bauteil gemäß einem der vorherigen Ansprüche,
bei dem die zumindest eine Verankerungsstruktur (1a) ein Durchbruch im Trägerstreifen ist.

8. Optoelektronisches Bauteil gemäß einem der vorherigen Ansprüche,
bei dem das elektrisch isolierende Material (3) Epoxidharz enthält.

9. Optoelektronisches Bauteil gemäß einem der vorherigen Ansprüche,
bei dem das elektrisch isolierende Material (3) Füllstoffpartikel enthält, die den thermischen Ausdehnungskoeffizienten des Anschlussträgers reduzieren.

10. Optoelektronisches Bauteil gemäß einem der vorherigen Ansprüche,
bei dem das elektrisch isolierende Material einen Haftvermittler enthält, der die Haftung an den Trägerstreifen (1) erhöht.

11. Optoelektronisches Bauteil gemäß einem der vorherigen Ansprüche,
bei dem der Trägerstreifen (1) einen Grundkörper (6) umfasst, der Kupfer enthält, wobei der Grundkörper (6) stellenweise mit einer Schicht (7) bedeckt ist, die zumindest eines der folgenden Metalle enthält: Silber, Nickel, Platin, Gold, Palladium.

12. Optoelektronisches Bauteil gemäß einem der vorherigen Ansprüche,
bei dem der Anschlussträger (10) kavitätsfrei ist.

13. Verfahren zur Herstellung eines optoelektronisches Bauteils mit den folgenden Schritten:
- Bereitstellen eines Trägerstreifens (1),
- Strukturieren des Trägerstreifens (1) mittels eines Ätzverfahrens (9),
- Ausfüllen von Zwischenräumen (2) des Trägerstreifens (1) mit einem elektrisch isolierenden Material (3) mittels eines Siebdruckverfahrens zur Bildung eines Anschlussträgers (10), und
- Aufbringen einer Vielzahl von optoelektronischen Halbleiterchips (4) auf den Trägerstreifen (1), wobei ein optoelektronisches Bauteil gemäß einem der Ansprüche 1 bis 12 hergestellt wird.

14. Verfahren gemäß Anspruch 13,
wobei die optoelektronischen Halbleiterchips (4) mit einem Vergussmaterial zur Bildung eines Vergusskörpers (8) umhüllt werden und die Anordnung aus Anschlussträger (1), optoelektronischen Halbleiterchips (4) und Vergusskörper (8) zu optoelektronischen Bauteilen vereinzelt wird, wobei die Vereinzelung (11) durch den Vergusskörper (8) hindurch erfolgt.

## Claims

1. An optoelectronic component having
- a connection carrier (10), comprising a structured carrier strip (1), in which interspaces (2) are filled with an electrically insulating material (3),
- and an optoelectronic semiconductor chip (4), which is attached and electrically connected to the top (10a) of the connection carrier, wherein
- the electrically insulating material (3) terminates flush with the carrier strip (1) in places or the carrier strip (1) projects beyond the electrically insulating material (3), and
- the carrier strip (1) is not covered by the electrically insulating material (3) on the top (10a) and/or on the bottom (10b) of the connection carrier, **characterized in that**
- the optoelectronic semiconductor chip (4) is surrounded by a potting body (8), which contains a silicone and in places directly adjoins the electrically insulating material (3) of the connection carrier (10), and
- the electrically insulating material (3) contains a silicone or consists of a silicone.

2. An optoelectronic component according to the preceding claim,
in which the potting body (8) and the connection carrier (10) comprise singulation traces.

3. An optoelectronic component according to either one of the preceding claims,
in which the carrier strip (1) comprises at least one anchoring structure (1a), in particular in the form of undercuts, wherein the anchoring structure (1a) improves adhesion of the electrically insulating material (3) to the carrier strip.

4. An optoelectronic component according to any one of the preceding claims,
in which the carrier strip (1) comprises a T-shaped cross-section at least in places.

5. An optoelectronic component according to any one of the preceding claims,
in which the carrier strip (1) comprises a mushroom-shaped cross-section at least in places.

6. An optoelectronic component according to any one of the preceding claims,
in which the at least one anchoring structure (1a) is produced by etching.

7. An optoelectronic component according to any one of the preceding claims,
in which the at least one anchoring structure (1a) is an opening in the carrier strip.

8. An optoelectronic component according to any one of the preceding claims,
in which the electrically insulating material (3) contains epoxy resin.

9. An optoelectronic component according to any one of the preceding claims,
in which the electrically insulating material (3) contains filler particles, which reduce the coefficient of thermal expansion of the connection carrier.

10. An optoelectronic component according to any one of the preceding claims,
in which the electrically insulating material contains an adhesion promoter, which increases adhesion to the carrier strip (1).

11. An optoelectronic component according to any one of the preceding claims,
in which the carrier strip (1) comprises a main body (6) containing copper, wherein the main body (6) is covered in places with a layer (7), which contains at least one of the following metals: silver, nickel, platinum, gold, palladium.

12. An optoelectronic component according to any one of the preceding claims,
in which the connection carrier (10) is cavity-free.

13. A method for producing an optoelectronic component, comprising the following steps:
- providing a carrier strip (1),
- structuring the carrier strip (1) by means of an etching method (9),
- filling interspaces (2) of the carrier strip (1) with an electrically insulating material (3) by means of a screen printing method to form a connection carrier (10), and applying a plurality of optoelectronic semiconductor chips (4) to the carrier strip (1),
wherein an optoelectronic component according to any one of claims 1 to 12 is produced.

14. A method according to claim 13,
wherein the optoelectronic semiconductor chips (4) are enveloped with a potting material to form a potting body (8) and the arrangement consisting of connection carrier (1), optoelectronic semiconductor chips (4) and potting body (8) is singulated to yield optoelectronic components, wherein singulation (11) proceeds through the potting body (8).

## Revendications

1. Composant optoélectronique présentant
- un support de connexion (10), présentant une bandelette support (1) structurée, dont des espaces intermédiaires (2) sont remplis d'un matériau (3) électriquement isolant,
- et une puce (4) à semi-conducteur optoélectronique, qui est fixée et reliée électriquement sur un côté supérieur (10a) du support de connexion,
- le matériau (3) électriquement isolant étant par endroits affleurant à la bandelette support (1) ou la bandelette support (1) dépassant du matériau (3) électriquement isolant, et
- la bandelette support (1), sur le côté supérieur (10a) et/ou un côté inférieur (10b) du support de connexion, n'étant pas recouverte par le matériau (3) électriquement isolant, **caractérisée en ce que**
- la puce (4) à semi-conducteur optoélectronique est entourée par un corps de scellement (8) qui contient une silicone et qui est, par endroits, directement adjacent au matériau (3) électriquement isolant du support de connexion (10) et
- le matériau (3) électriquement isolant contient une silicone ou est constitué par une silicone.

2. Composant optoélectronique selon la revendication précédente,
dont le corps de scellement (8) et le support de connexion (10) présentent des traces de séparation.

3. Composant optoélectronique selon l'une quelconque des revendications précédentes,
dont la bandelette support (1) présente au moins une structure (1a) d'encrage, en particulier sous forme de contre-dépouille, la structure (1a) d'encrage améliorant l'adhérence du matériau (3) électriquement isolant à la bandelette support.

4. Composant optoélectronique selon l'une quelconque des revendications précédentes,
dont la bandelette support (1) présente, au moins par endroits, une section transversale en forme de T.

5. Composant optoélectronique selon l'une quelconque des revendications précédentes,
dont la bandelette support (1) présente, au moins par endroits, une section transversale en forme de champignon.

6. Composant optoélectronique selon l'une quelconque des revendications précédentes,
dont ladite au moins une structure (1a) d'ancrage est produite par gravure.

7. Composant optoélectronique selon l'une quelconque des revendications précédentes,
dont ladite au moins une structure (1a) d'ancrage est une ouverture dans la bandelette support.

8. Composant optoélectronique selon l'une quelconque des revendications précédentes,
dont le matériau (3) électriquement isolant contient une résine époxyde.

9. Composant optoélectronique selon l'une quelconque des revendications précédentes,
dont le matériau (3) électriquement isolant contient des particules de charge, qui réduisent le coefficient de dilatation thermique du support de connexion.

10. Composant optoélectronique selon l'une quelconque des revendications précédentes,
dont le matériau électriquement isolant contient un promoteur d'adhérence qui augmente l'adhérence à la bandelette support (1).

11. Composant optoélectronique selon l'une quelconque des revendications précédentes,
dont la bandelette support (1) comprend un corps de base (6), qui contient du cuivre, le corps de base (6) étant revêtu par endroits par une couche (7) qui contient au moins un des métaux suivants : argent, nickel, platine, or, palladium.

12. Composant optoélectronique selon l'une quelconque des revendications précédentes,
dont le support de connexion (10) est exempt de cavités.

13. Procédé pour la fabrication d'un composant optoélectronique, présentant les étapes suivantes :
- mettre à disposition une bandelette support (1);
- structurer la bandelette support (1) au moyen d'un procédé de gravure (9),
- remplir des espaces intermédiaires (2) de la bandelette support (1) par un matériau (3) électriquement isolant au moyen d'un procédé de sérigraphie pour former un support de connexion (10) et
- appliquer une multitude de puces (4) à semi-conducteur optoélectroniques sur la bandelette support (1), ce qui permet de fabriquer un composant optoélectronique selon l'une quelconque des revendications 1 à 12.

14. Procédé selon la revendication 13,
les puces (4) à semi-conducteur optoélectroniques étant enveloppées par un matériau de scellement pour former un corps de scellement (8) et la disposition constituée par le support de connexion (10), les puces (4) à semi-conducteur optoélectroniques et le corps de scellement (8) étant séparée en pièces optoélectroniques, la séparation (11) ayant lieu à travers le corps de scellement (8).
